(19) **Europäisches Patentamt / European Patent Office / Office européen des brevets**

(11) **EP 3 812 721 B1**

(12) **EUROPEAN PATENT SPECIFICATION**

(45) Date of publication and mention of the grant of the patent:
**05.07.2023 Bulletin 2023/27**

(21) Application number: **20203567.1**

(22) Date of filing: **23.10.2020**

(51) International Patent Classification (IPC):
$G01J\ 3/02^{(2006.01)}$ $G01J\ 3/18^{(2006.01)}$
$G01J\ 3/28^{(2006.01)}$ $H01L\ 27/146^{(2006.01)}$
$H04N\ 23/55^{(2023.01)}$

(52) Cooperative Patent Classification (CPC):
**G01J 3/2823; G01J 3/0208; G01J 3/0256; G01J 3/18; G01J 3/2803; H01L 27/14625; H04N 23/55;** G01J 2003/2826

(54) **HYPERSPECTRAL IMAGE PICKUP APPARATUS PROVIDING A HYPERSPECTRAL IMAGE FROM A RGB IMAGE**

HYPERSPEKTRALE BILDAUFNAHMEVORRICHTUNG, DAS EIN HYPERSPEKTRALES BILD AUS EINEM RGB-BILD ERZEUGT

APPAREIL DE CAPTURE D'IMAGES HYPERSPECTRALES FOURNISSANT UNE IMAGE HYPERSPECTRALE À PARTIR D'UNE IMAGE RGB

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.10.2019 KR 20190133269**

(43) Date of publication of application:
**28.04.2021 Bulletin 2021/17**

(73) Proprietor: **Samsung Electronics Co., Ltd. Gyeonggi-do 16677 (KR)**

(72) Inventors:
• **ROH, Younggeun**
**16678 Suwon-si, Gyeonggi-do (KR)**
• **KIM, Hyochul**
**16678 Suwon-si, Gyeonggi-do (KR)**

(74) Representative: **Grünecker Patent- und Rechtsanwälte PartG mbB Leopoldstraße 4 80802 München (DE)**

(56) References cited:
EP-A2- 1 339 237 WO-A1-2017/188956
WO-A1-2017/210781 US-A1- 2009 180 115
US-A1- 2010 013 979 US-A1- 2013 235 249
US-A1- 2019 246 032 US-B1- 9 426 383

EP 3 812 721 B1

**Description**

**BACKGROUND**

1. Field

Example embodiments of the present disclosure relate to a hyperspectral image sensor and a hyperspectral image pickup apparatus including the hyperspectral image sensor, and more particularly, to a miniaturized hyperspectral image sensor, which has a small size by arranging a dispersion optical device in an image sensor, and a hyperspectral image pickup apparatus including the miniaturized hyperspectral image sensor.

2. Description of Related Art

Hyperspectral imaging is a technique for simultaneously analyzing an image of an object and measuring a continuous light spectrum for each point in the image. In hyperspectral imaging technique, the light spectrum of each portion of an object may be more quickly measured compared to existing spot spectroscopy. Because each pixel in an image of an object contains spectral information, various applications of remotely capturing an image of an object and determining the properties and characteristics of the object may be implemented. For example, hyperspectral imaging may be used for ground surveying using drones, satellites, aircraft, etc., analyzing agricultural site conditions, mineral distribution, surface vegetation, and pollution levels, etc. In addition, use of hyperspectral imaging in various fields such as food safety, skin/face analysis, authentication recognition, and biological tissue analysis has been investigated.

In hyperspectral imaging, light passing through a narrow aperture, like in a point scan method (i.e., whisker-broom method) or a line scan method (i.e., push-broom method), is dispersed on a grid or the like to simultaneously obtain an image of an object and a spectrum. Recently, a snapshot method of combining a band pass filter array or a tunable filter with an image sensor and simultaneously capturing images for wavelength bands has also been introduced.

However, when the point scan method or the line scan method is used, it is difficult to miniaturize an image pickup apparatus because a mechanical configuration for scanning an aperture is required. When the snapshot method is used, the measurement time is long and the resolution of the image is lowered.

Hyperspectral imaging devices based on dispersive elements are for example known from US 9 426 383 B1, US 2010/013979 A1, US 2009/180115 A1 and EP 1 339 237 A2.

SUMMARY

One or more unclaimed examples provide miniaturized hyperspectral image sensors.

One or more example embodiments provide miniaturized hyperspectral image pickup apparatuses including miniaturized hyperspectral image sensors.

Additional aspects will be set forth in part in the description which follows and, in part, will be apparent from the description, or may be learned by practice of example embodiments of the disclosure.

According to an aspect of an example embodiment, there is provided a hyperspectral image pickup apparatus according to claim 1.

The hyperspectral image pickup apparatus may further include a transparent spacer disposed on the light sensing surface of the solid-state imaging device, wherein the dispersion optical device is disposed on an upper surface of the transparent spacer opposite to the solid-state imaging device.

The dispersion optical device may include a periodic grating structure or an aperiodic grating structure, or a one-dimensional structure, a two-dimensional structure, or a three-dimensional structure including materials having different refractive indices.

The size of the dispersion optical device may correspond to all of the plurality of pixels of the solid-state imaging device.

The hyperspectral image pickup apparatus may further include an objective lens configured to focus incident light on the light sensing surface of the solid-state imaging device.

The dispersion optical device may be configured to cause chromatic dispersion and focus incident light on the solid-state imaging device.

The hyperspectral image pickup apparatus may further include a spacer disposed on an upper surface of the dispersion optical device, and a planar lens disposed on an upper surface of the spacer, wherein the planar lens is configured to focus incident light on the solid-state imaging device.

According to the invention, the image processor is further configured to extract a hyperspectral image based on the image data provided from the solid-state imaging device and a point spread function previously calculated for each of the plurality of wavelengths.

The image processor is further configured to extract edge information without dispersion through edge reconstruction of a dispersed RGB image input from the solid-state imaging device, obtain spectral information in a gradient domain based on dispersion of the extracted edge information, and reconstruct a hyperspectral image based on spectral information of gradients.

The image processor may be further configured to obtain a spatially aligned hyperspectral image $i_{aligned}$ by solving a convex optimization problem by:

$$i_{aligned} = \underset{i}{\arg\min} \underbrace{\left\| \Omega\Phi i - j \right\|_2^2}_{\text{data term}} + \underbrace{\alpha_1 \left\| \nabla_{xy} i \right\|_1 + \beta_1 \left\| \nabla_\lambda \nabla_{xy} i \right\|_1}_{\text{prior terms}}$$

, where $\Omega$ is a response characteristic of the solid-state imaging device, $\Phi$ is a point spread function, j is dispersed RGB image data input from the solid-state imaging device, i is a vectorized hyperspectral image, $\nabla_{xy}$ is a spatial gradient operator, and $\nabla_\lambda$ is a spectral gradient operator.

The image processor may be further configured to solve the convex optimization problem based on an alternating direction method of multipliers (ADMM) algorithm.

The image processor may be further configured to reconstruct the spectral information from data of the spatially aligned hyperspectral image by solving an optimization problem to extract a stack $\hat{g}_{xy}$ of spatial gradients for each

$$\hat{g}_{xy} = \underset{g_{xy}}{\arg\min} \underbrace{\left\| \Omega\Phi g_{xy} - \nabla_{xy} j \right\|_2^2}_{\text{data term}} + \underbrace{\alpha_2 \left\| \nabla_\lambda g_{xy} \right\|_1 + \beta_2 \left\| \nabla_{xy} g_{xy} \right\|_2^2}_{\text{prior terms}}$$

wavelength by: , where $g_{xy}$ is a spatial gradient close to a spatial gradient $\nabla_{xy} j$ of an image in the solid-state imaging device.

The image processor may be further configured to reconstruct a hyperspectral image $i_{opt}$ from the stack $\hat{g}_{xy}$ of spatial gradients by solving an optimization problem by:

$$i_{opt} = \underset{i}{\arg\min} \underbrace{\left\| \Omega\Phi i - j \right\|_2^2 + \alpha_3 \left\| W_{xy} \odot \left( \nabla_{xy} i - \hat{g}_{xy} \right) \right\|_2^2}_{\text{data terms}} + \underbrace{\beta_3 \left\| \Delta_\lambda i \right\|_2^2}_{\text{prior term}}$$

, where $\Delta_\lambda$ is a Laplacian operator for a spectral image i along a spectral axis, and $W_{xy}$ is an element-wise weighting matrix that determines the confidence level of gradients estimated in the previous stage.

The image processor may further include a neural network structure configured to repeatedly perform an optimization process by using a gradient descent

$$I^{(l+1)} = I^{(l)} - \varepsilon \left[ \Phi^\top \left( \Phi I^{(l)} - J \right) + \varsigma \left( I^{(l)} - V^{(l)} \right) \right]$$

$$= \bar{\Phi} I^{(l)} + \varepsilon I^{(0)} + \varepsilon\varsigma V^{(l)}$$

method by: , where $I^{(l)}$ and $V^{(l)}$ are solutions for l-th HQS iteration, a condition

$$\bar{\Phi} = \left[ (1 - \varepsilon\varsigma) 1 - \varepsilon\Phi^\top\Phi \right] \in \mathbb{R}^{WH\Lambda \times WH\Lambda}$$

is satisfied, $\Phi$ is a point spread function, J is dispersed RGB image data input from the solid-state imaging device, I is a vectorized hyperspectral image, $\varepsilon$ is a gradient descent step

size, $\varsigma$ is a penalty parameter, V is an auxiliary variable $V \in \mathbb{R}^{WH\Lambda \times 1}$ , and W, H, and $\Lambda$ are the width of a spectral image, the height of the spectral image, and the number of wavelength channels of the spectral image, respectively.

The neural network structure of the image processor may be further configured to receive image data J from the solid-state imaging device, obtain an initial value $I^{(0)}$ of a hyperspectral image based on the image data J, iteratively perform the optimization process with respect to the equation based on a gradient descent method, and output a final hyperspectral image based on the iterative optimization process.

The image processor may be further configured to obtain a prior term, which is the third term of the equation, by using a neural network.

The neural network may include a U-net neural network.

The neural network may further include an encoder including a plurality of pairs of a convolution layer and a pooling layer, and a decoder including a plurality of pairs of an up-sampling layer and a convolution layer, wherein a number of pairs of the up-sampling layer and the convolution layer of the decoder is equal to a number of pairs of the convolution layer and the pooling layer of the encoder, and wherein a skip connection method is applied between the convolution layer of the encoder and the convolution layer of the decoder, which have a same data size.

The neural network may further include an output layer configured to perform soft thresholding, based on an activation function, on the output of the decoder.

## BRIEF DESCRIPTION OF THE DRAWINGS

The above and/or other aspects, features, and advantages of example embodiments will be more apparent from the following description taken in conjunction with the accompanying drawings, in which:

FIG. 1 is a schematic cross-sectional view illustrating the configuration of a hyperspectral image pickup apparatus including a hyperspectral image sensor according to an example embodiment;
FIGS. 2A to 2D illustrate various patterns of a dispersion optical device of the hyperspectral image sensor shown in FIG. 1;
FIG. 3A illustrates a line-shaped reference image formed on the focal plane of an objective lens when a dispersion optical device is not used;
FIG. 3B illustrates line-shaped images separated for each wavelength, which are formed on the focal plane of an objective lens when a dispersion optical device is used;
FIG. 4A illustrates an example of a three-dimensional hyperspectral data cube before dispersion, FIG. 4B illustrates an example of a three-dimensional hyperspectral data cube dispersed by a dispersion optical device, and FIG. 4C illustrates a state in which a dispersed spectrum is projected onto an image sensor;
FIG. 5 is a block diagram conceptually illustrating a neural network structure for performing an optimization process to obtain a hyperspectral image;
FIG. 6 is a block diagram conceptually illustrating a neural network structure of a second operation unit for calculating a prior term shown in FIG. 5;
FIG. 7 is a schematic cross-sectional view illustrating the configuration of a hyperspectral image pickup apparatus according to another example embodiment; and
FIG. 8 is a schematic cross-sectional view illustrating the configuration of a hyperspectral image pickup apparatus according to another example embodiment.

## DETAILED DESCRIPTION

Reference will now be made in detail to example embodiments of which are illustrated in the accompanying drawings, wherein like reference numerals refer to like elements throughout. In this regard, the example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, a hyperspectral image sensor and a hyperspectral image pickup apparatus including the hyperspectral image sensor will be described in detail with reference to the accompanying drawings. In the following drawings, the size of each layer illustrated in the drawings may be exaggerated for convenience of explanation and clarity. Furthermore, the example embodiments are merely described below, by referring to the figures, to explain aspects of the present description, and the example embodiments may have different forms. In the layer structure described below, when a constituent element is disposed "above" or "on" to another constituent element, the constituent element may include not only an element directly contacting on the upper/lower/left/right sides of the other constituent element, but also an element disposed above/under/left/right the other constituent element in a non-contact manner.

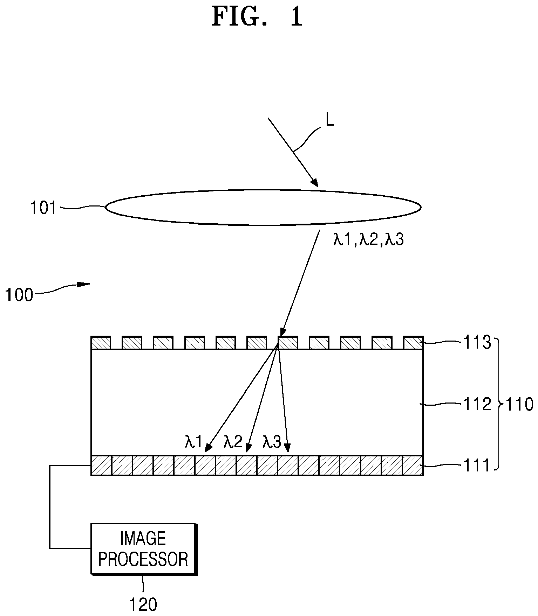

FIG. 1 is a schematic cross-sectional view illustrating the configuration of a hyperspectral image pickup apparatus 100 including a hyperspectral image sensor 110 according to an example embodiment. Referring to FIG. 1, the hyperspectral image pickup apparatus 100 according to the example embodiment may include an objective lens 101, the hyperspectral image sensor 110, and an image processor 120. In addition, the hyperspectral image sensor 110 according to an example embodiment may include a solid-state imaging device 111, a spacer 112, and a dispersion optical device 113.

The solid-state imaging device 111 senses light and is configured to convert the intensity of incident light into an electrical signal. The solid-state imaging device 111 may be a general image sensor including a plurality of pixels arranged in two dimensions to sense light. For example, the solid-state imaging device 111 may include a charge coupled device (CCD) image sensor or a complementary metal oxide semiconductor (CMOS) image sensor.

The spacer 112 disposed on a light incident surface of the solid-state imaging device 111 provides a constant gap between the dispersion optical device 113 and the solid-state imaging device 111. The spacer 112 may include a transparent dielectric material such as silicon oxide ($SiO_2$), silicon nitride ($SiN_x$), or hafnium oxide ($HfO_2$), or may include a transparent polymer material such as polymethly methacrylate (PMMA) or polyimide (PI). In addition, the spacer 112 may include air if there is a support structure for maintaining a constant gap between the dispersion optical device 113 and the solid-state imaging device 111.

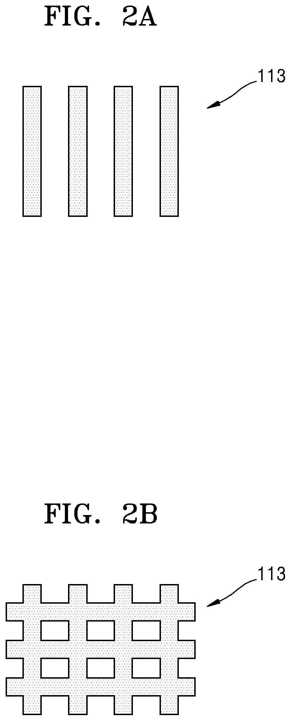

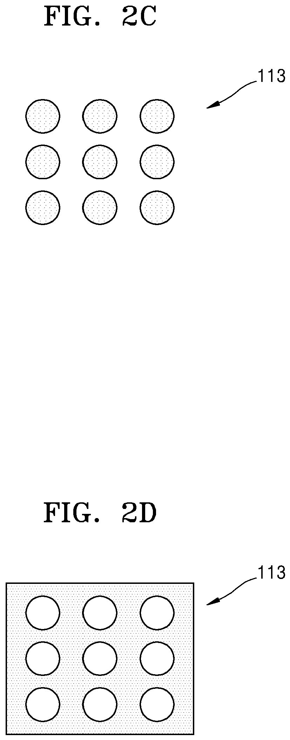

The dispersion optical device 113 disposed on an upper surface of the spacer 112 is configured to intentionally cause chromatic dispersion. For example, the dispersion optical device 113 may include a periodic one-dimensional grating structure or two-dimensional grating structure configured to have chromatic dispersion characteristics. The dispersion optical device 113 may be configured in various patterns. For example, FIGS. 2A to 2D illustrate various patterns of the dispersion optical device 113 of the hyperspectral image sensor 110 shown in FIG. 1. As shown in FIGS. 2A to 2D, the dispersion optical device 113 may include a periodic grating structure configured in various patterns to cause chromatic dispersion. In addition, the dispersion optical device 113 may include a grating having an asymmetric pattern or an aperiodic pattern, may include various forms of meta surfaces, or may include photonic crystals having various one-dimensional, two-dimensional, or three-dimensional structures. For example, the dispersion optical device 113 may include a one-dimensional or two-dimensional periodic structure or non-periodic structure, a three-dimensional stacked structure, or the like, which includes materials having different refractive indices. The dispersion optical device 113 diffracts incident light at different angles for each wavelength of the incident light. In other words, the dispersion optical device 113 disperses the incident light at different dispersion angles depending on the wavelength of the incident light. Therefore, the light transmitted through the dispersion optical device 113 proceeds at different angles according to the wavelength of the light.

The dispersion optical devices 113 may be disposed to face the entire area of the solid-state imaging device 111 at a regular interval. For example, the size of the dispersion optical device 113 may be selected to entirely cover an effective area in which a plurality of pixels of the solid-state imaging device 111 are arranged. The dispersion optical device 113 may have the same dispersion characteristic in the entire area of the dispersion optical device 113. However, embodiments are not limited thereto. For example, the dispersion optical device 113 may have a plurality of areas having different dispersion characteristics. For example, the dispersion optical device 113 may have at least two areas having different dispersion angles for the same wavelength of light.

The solid-state imaging device 111 of the hyperspectral image sensor 110 may be disposed on the focal plane of the objective lens 101. In addition, the hyperspectral image sensor 110 may be disposed such that the dispersion optical device 113 faces the objective lens 101. The hyperspectral image sensor 110 may be disposed such that the dispersion optical device 113 is positioned between the solid-state imaging device 111 and the objective lens 101. Then, the objective lens 101 may focus incident light L on a light sensing surface of the solid-state imaging device 111. In this case, the incident light L that passes through the objective lens 101 and enters the hyperspectral image sensor 110 is separated for each wavelength by the dispersion optical device 113. Light $\lambda 1$, $\lambda 2$, and $\lambda 3$ separated for each wavelength pass through the spacer 112 and are incident on different positions on the light sensing surface of the solid-state imaging device 111.

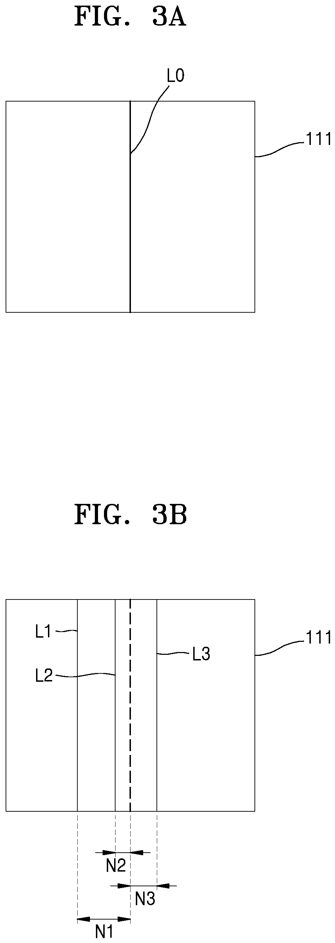

For example, FIG. 3A illustrates a line-shaped reference image L0 formed on the focal plane of the objective lens 101 when the dispersion optical device 113 is not present, and FIG. 3B illustrates line-shaped images, for example, a first image L1, a second image L2, and a third image L3, separated for each wavelength of light, which are formed on the focal plane of the objective lens 101 when the dispersion optical device 113 is used according to an example embodiment. As shown in FIG. 3B, the first image L1 having a first wavelength may move to the left by N1 pixels of the solid-state imaging device 111, on the solid-state imaging device 111, compared to the reference image L0. The second image L2 having a second wavelength may move to the left by N2 pixels of the solid-state imaging device 111, on the solid-state imaging device 111, compared to the reference image L0. The third image L3 having a third wavelength may move to the right by N3 pixels of the solid-state imaging device 111, on the solid-state imaging device 111, compared to the reference image L0.

The difference in the number of pixels between the positions of the a first image L1, a second image L2, and a third image L3 and the position of the reference image L0 on the solid-state imaging device 111 may be determined by a diffraction angle for each wavelength of light by the dispersion optical device 113, the thickness of the spacer 112, the pixel pitch of the solid-state imaging device 111, and the like. For example, as the diffraction angle by the dispersion optical device 113 increases, the thickness of the spacer 112 increases, or the pixel pitch of the solid-state imaging device 111 decreases, the difference in the number of pixels between the positions of the a first image L1, a second image L2, and a third image L3 and the position of the reference image L0 may increase. The diffraction angle for each wavelength of light by the dispersion optical device 113, the thickness of the spacer 112, and the pixel pitch of the solid-state imaging device 111 are values that may be known in advance through measurement.

Therefore, when the a first image L1, a second image L2, and a third image L3 are detected on the solid-state imaging device 111, an image for each spectrum, that is, a hyperspectral image may be extracted in consideration of the diffraction angle for each wavelength of light by the dispersion optical device 113, the thickness of the spacer 112, and the pixel pitch of the solid-state imaging device 111. For example, the image processor 120 may process image data provided from the solid-state imaging device 111, thereby extracting the first image L1 formed by light having the first wavelength, the second image L2 formed by light having the second wavelength, and the third image L3 formed by light having the third wavelength. Although only images for three wavelengths are shown in FIG. 3B for convenience, the image processor 120 may extract hyperspectral images for dozens or more of wavelengths of light.

In FIG. 3A and FIG. 3B, for ease of understanding, light shown in the form of a simple line is incident on the dispersion optical device 113 at only one angle. However, light is actually incident from the objective lens 101 onto the dispersion optical device 113 at various angles, and an image formed on the solid-state imaging device 111 has a complex shape including blurring. In order to comprehensively consider light at various angles and various wavelengths reaching the solid-state imaging device 111 from the objective lens 101 through the dispersion optical device 113, a point spread function is calculated for each wavelength in advance for an optical path from one point on an object to the solid-state imaging device 111 through the objective lens 101, the dispersion optical device 113, and the spacer 112. Then, the blurring of the image due to chromatic aberration is reconstructed based on the calculated point spread function. For example, by detecting the edge of an image obtained from the solid-state imaging device 111 and analyzing how many pixels the edge of the image has been shifted for each wavelength, an image of each wavelength may be inversely calculated by using the point spread function calculated in advance.

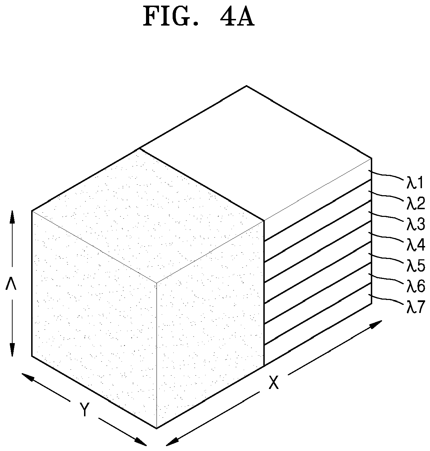

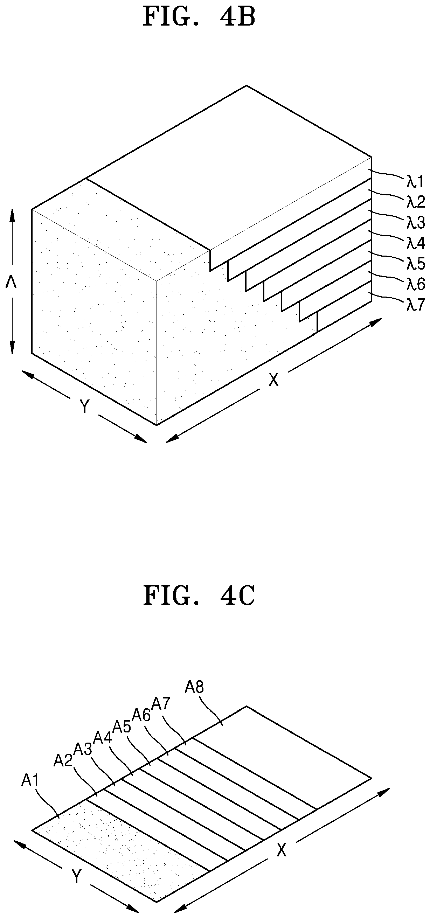

Hereinafter, a process of calculating a hyperspectral image by using an image obtained from the solid-state imaging device 111 will be described in more detail. FIG. 4A illustrates an example of a three-dimensional hyperspectral data cube before being dispersed, FIG. 4B illustrates an example of a three-dimensional hyperspectral data cube dispersed by the dispersion optical device 113, and FIG. 4C illustrates a state in which a dispersed spectrum is projected onto an image sensor. As shown in FIGS. 4A and 4B, a hyperspectral image may be represented by a three-dimensional cube I(p, λ) including a horizontal axis X, a vertical axis Y, and a spectral axis Λ. Here, p represents the coordinates (x, y) of a pixel of the solid-state imaging device 111, and λ represents a wavelength.

Referring to FIG. 4A, the edges of images respectively having a first wavelength λ1, a second wavelength λ2, a third wavelength λ3, a fourth wavelength λ4, a fifth wavelength λ5, a sixth wavelength λ6, and a seventh wavelength λ7 coincide with each other before dispersion. However, referring to FIG. 4B, when dispersion occurs along the horizontal axis X due to the dispersion optical device 113, spectral information gradually differently shifts in accordance with the wavelength in the direction of the horizontal axis X. Referring to FIG. 4C, as a dispersed spectrum is projected onto the solid-state imaging device 111, the pixels of the solid-state imaging device 111 obtain two-dimensional spectral information accumulated along the spectral axis Λ. For example, in FIG. 4C, no light is incident on a first area A1, only light having the first wavelength λ1 is projected on a second area A2, and light having the first and second wavelengths λ1 and λ2 is projected on a third area A3. In addition, light having the first to third wavelengths λ1 to λ3 is projected on a fourth area A4, light having the first to fourth wavelengths λ1 to λ4 is projected on a fifth area A5, light having the first to fifth wavelengths λ1 to λ5 is projected on a sixth area A6, light having the first to sixth wavelengths λ1 to λ6 is projected on a seventh area A7, and light having the first to seventh wavelengths λ1 to λ7 is projected on an eighth area A8.

Therefore, image data obtained by the solid-state imaging device 111 may be expressed by Equation 1 below.

[Equation 1]

$$J(p,c) = \int \Omega(c,\lambda) I(\Phi_\lambda(p),\lambda) d\lambda$$

Here, J(p, c) denotes linear RGB image data obtained by the solid-state imaging device 111, c denotes an RGB channel, and Ω(c, λ) denotes a transfer function obtained by coding the response of the solid-state imaging device 111 to the channel c and the wavelength λ. In addition, $\Phi_\lambda(p)$ denotes a nonlinear dispersion spatially changed by the dispersion optical device 113 and is modeled as a shift operator at each pixel p for each wavelength λ. Rewriting this model in the form of a matrix-vector gives Equation 2 below.

**[Equation 2]**

$$j = \Omega\Phi i$$

Here, j denotes a vectorized linear RGB image, i denotes a vectorized hyperspectral image, and $\Omega$ denotes an operator for converting spectral information into RGB. $\Phi$ denotes a matrix representing the direction and magnitude of dispersion per pixel. Therefore, FIG. 4A shows i, FIG. 4B shows $\Phi i$, and FIG. 4C shows j or $\Omega\Phi i$.

In the example embodiment, j may be obtained through the solid-state imaging device 111, and $\Omega$ may be obtained from the response characteristics of the solid-state imaging device 111, that is, the optical characteristics of a color filter of the solid-state imaging device 111 and the response characteristics of a photosensitive layer of the solid-state imaging device 111. $\Phi$ may also be obtained from a point spread function for the optical path from one point on the object to the solid-state imaging device 111 through the objective lens 101, the dispersion optical device 113, and the spacer 112. Therefore, in consideration of $\Omega$ and $\Phi$, a hyperspectral image for each wavelength may be calculated using an RGB image obtained from the solid-state imaging device 111.

However, input data for obtaining the hyperspectral image is only the RGB image obtained through the solid-state imaging device 111. The RGB image obtained through the solid-state imaging device 111 includes only superimposed dispersion information and spectral signatures at edges of the image. Therefore, reconstructing the hyperspectral image may be a problem for which a plurality of solutions may exist. In order to solve this problem, according to the invention, first, clear edge information without dispersion is obtained through edge reconstruction of an input dispersion RGB image, and next, spectral information is calculated in a gradient domain by using the dispersion of extracted edges, and finally, a hyperspectral image is reconstructed using sparse spectral information of gradients.

For example, by solving a convex optimization problem as shown in Equation 3 below, a spatially aligned hyperspectral image $i_{aligned}$ may be calculated from an input dispersion RGB image j.

**[Equation 3]**

$$i_{aligned} = \arg\min_{i} \underbrace{\left\|\Omega\Phi i - j\right\|_2^2}_{\text{data term}} + \underbrace{\alpha_1\left\|\nabla_{xy}i\right\|_1 + \beta_1\left\|\nabla_\lambda\nabla_{xy}i\right\|_1}_{\text{prior terms}}$$

Here, $\nabla_{xy}$ denotes a spatial gradient operator and $\nabla_\lambda$ denotes a spectral gradient operator. $\alpha_1$ and $\beta_1$ denote coefficients. The first term of Equation 3 denotes a data residual of an image formation model shown in Equation 2, and the remaining term is a prior term. A first prior term is a traditional total variation (TV) term that ensures the sparsity of spatial gradients, and a second prior term is a cross-channel term. The cross-channel term is used to calculate the difference between unnormalized gradient values of adjacent spectral channels, assuming that spectral signals are locally smooth in adjacent channels. Therefore, spatial alignment between the spectral channels may be obtained using the cross-channel term. Equation 3 may be solved through, for example, L1 regularization or L2 regularization using an alternating direction method of multipliers (ADMM) algorithm.

Using this method, a hyperspectral image without edge dispersion may be obtained. However, even in this case, aligned spectral information in the spatially aligned hyperspectral image $i_{aligned}$ may not be completely accurate. In order to locate the edge more accurately, a multi-scale edge detection algorithm may be applied after projecting the aligned hyperspectral image $i_{aligned}$ onto an RGB channel via a transfer function $\Omega i_{aligned}$, instead of applying an edge detection algorithm directly to spectral channels in the aligned hyperspectral image $i_{aligned}$.

The extracted edge information is used to reconstruct spectral information. In an image without dispersion, spectral information is directly projected to RGB values, and thus, a spectrum may not be traced back from a given input. However, when there is dispersion, information about spectral intensity distribution along the edge may be obtained using a spatial gradient. Therefore, in order to reconstruct the spectral information, spatial gradients in dispersed areas near the edge is considered. First, a spatial gradient $g_{xy}$ close to spatial gradients $\nabla_{xy}j$ of an image obtained by the solid-state imaging device 111 may be found, and a stack $g_{xy}$ of spatial gradients for each wavelength may be calculated as in Equation 4 below.

[Equation 4]

$$\hat{g}_{xy} = \underset{g_{xy}}{\arg\min} \underbrace{\left\|\Omega\Phi g_{xy} - \nabla_{xy}j\right\|_2^2}_{\text{data term}} + \underbrace{\alpha_2\left\|\nabla_\lambda g_{xy}\right\|_1 + \beta_2\left\|\nabla_{xy}g_{xy}\right\|_2^2}_{\text{prior terms}}$$

Here, $\alpha_2$ and $\beta_2$ denote coefficients. The first term of Equation 4 is a data term representing an image formation model of Equation 1 in a gradient domain, and the remaining two terms are prior terms relating to gradients. A first prior term is equivalent to the spectral sparsity of gradients used in the spatial alignment stage of Equation 3, and enforces sparse changes of the gradients along a spectral dimension. A second prior term imposes smooth changes of the gradients in a spatial domain to remove artifacts of the image.

If a spectral signature exists only along edges, the optimization problem of Equation 4 may be solved considering only the pixels of the edges. For example, the optimization problem of Equation 4 may be solved through L1 regularization or L2 regularization using an ADMM algorithm.

After a stack $\hat{g}_{xy}$ of spatial gradients is obtained for each wavelength, the gradient information may be used as strong spectral cues for reconstructing a hyperspectral image $i_{opt}$. For example, in order to calculate the hyperspectral image $i_{opt}$ from the stack $\hat{g}_{xy}$ of the spatial gradients, an optimization problem such as Equation 5 below may be solved.

[Equation 5]

$$i_{opt} = \underset{i}{\arg\min} \underbrace{\left\|\Omega\Phi i - j\right\|_2^2 + \alpha_3\left\|W_{xy} \odot \left(\nabla_{xy}i - \hat{g}_{xy}\right)\right\|_2^2}_{\text{data terms}} + \underbrace{\beta_3\left\|\Delta_\lambda i\right\|_2^2}_{\text{prior term}}$$

Here, $\alpha_3$ and $\beta_3$ denotes coefficients. $\Delta_\lambda$ denotes a Laplacian operator for a spectral image i along a spectral axis, and $W_{xy}$ denotes an element-wise weighting matrix that determines the confidence level of gradients estimated in the previous stage. In order to consider the directional dependency of spectral cues, the matrix $W_{xy}$ that is a confidence matrix may be configured based on the previously extracted edge information and dispersion direction. For example, for non-edge pixels, high confidence is assigned to gradient values of 0. For edge pixels, different confidence levels are assigned to horizontal and vertical components, respectively. Then, gradient directions similar to the dispersion direction have a high confidence value. In particular, a confidence value $W_{k\in\{x,y\}}(p, \lambda)$, which is an element of the matrix $W_{xy}$ for the horizontal and vertical gradient components of a pixel p at the wavelength $\lambda$, is expressed by Equation 6 below.

[Equation 6]

$$W_{k\in\{x,y\}}(p,\lambda) = \begin{cases} \left|n_{k\in\{x,y\}}\right| & \text{if } p \text{ is an edge pixel} \\ 1 & \text{otherwise} \end{cases}$$

In Equation 5, a first data term may minimize errors in the image formation model of Equation 2, and a second data term may minimize the differences between the gradient $\nabla_{xy}i$ and the gradient $\hat{g}_{xy}$. In addition, the prior terms smooth a spectral curvature. The stability of spectral estimation may be improved by smoothing the spectral curvature along different wavelengths. To this end, Equation 5 may be solved using, for example, a conjugate gradient method.

The above-described process may be implemented by the image processor 120 performing arithmetic numerically. For example, the image processor 120 receives image data J having an RGB channel from the solid-state imaging device 111. The image processor 120 may be configured to extract clear edge information without dispersion through edge reconstruction of an input dispersion RGB image by performing a numerical analysis on the optimization problem of Equation 3. In addition, the image processor 120 may be configured to calculate spectral information in the gradient domain by using the dispersion of the extracted edges by performing a numerical analysis on the optimization problem of Equation 4. In addition, the image processor 120 may be configured to reconstruct a hyperspectral image by using sparse spectral information of gradients by performing a numerical analysis on the optimization problem of Equation 5.

The above optimization process may be performed using a neural network. First, Equation 2 is more simply expressed as Equation 7 below.

[Equation 7]

$$J = \Phi I$$

In Equation 7, $\Phi$ denotes the product of $\Omega$ and $\Phi$ described in Equation 2, J denotes a vectorized linear RGB image, and I denotes a vectorized hyperspectral image. Therefore, $\Phi$ in Equation 7 may be regarded as a point spread function considering the response characteristics of the solid-state imaging device 111.

When an unknown prior term described in Equation 3 is simply represented as R($\cdot$), a hyperspectral image $\hat{I} \in \mathbb{R}^{WH\Lambda \times 1}$ to be reconstructed may be expressed by Equation 8 below. Here, W, H, and $\Lambda$ denote the width of a spectral image, the height of the spectral image, and the number of wavelength channels of the spectral image, respectively.

[Equation 8]

$$\hat{I} = \arg\min_{I} \|J - \Phi I\|_2^2 + R(I)$$

In addition, by introducing an auxiliary variable $V \in \mathbb{R}^{WH\Lambda \times 1}$ and converting Equation 8 into a constrained optimization problem, Equation 9 below is obtained.

[Equation 9]

$$(\hat{I}, \hat{V}) = \arg\min_{I,V} \|J - \Phi I\|_2^2 + R(V) \quad \text{s.t.} \quad V = I.$$

By converting Equation 9 into an unconstrained optimization problem by using a half-quadratic splitting (HQS) method, Equation 10 below is obtained.

[Equation 10]

$$(\hat{I}, \hat{V}) = \arg\min_{I,V} \|J - \Phi I\|_2^2 + \varsigma \|V - I\|_2^2 + R(V)$$

Here, $\varsigma$ denotes a penalty parameter. Equation 10 may be solved by dividing Equation 10 into Equation 11 and Equation 12 below.

[Equation 11]

$$\mathbf{I}^{(l+1)} = \arg\min_{\mathbf{I}} \|\mathbf{J} - \Phi\mathbf{I}\|_2^2 + \varsigma \left\|\mathbf{V}^{(l)} - \mathbf{I}\right\|_2^2$$

[Equation 12]

$$\mathbf{V}^{(l+1)} = \arg\min_{\mathbf{V}} \varsigma \left\|\mathbf{V} - \mathbf{I}^{(l+1)}\right\|_2^2 + R(\mathbf{V})$$

Here, $I^{(l)}$ and $V^{(l)}$ denote solutions for l-th HQS iteration.

In order to reduce the amount of computation, Equation 11 may be solved using a gradient descent method. In this way, Equation 11 may be represented as Equation 13 below.

[Equation 13]

$$\mathbf{I}^{(l+1)} = \mathbf{I}^{(l)} - \varepsilon\left[\Phi^{\mathsf{T}}\left(\Phi\mathbf{I}^{(l)} - \mathbf{J}\right) + \varsigma\left(\mathbf{I}^{(l)} - \mathbf{V}^{(l)}\right)\right]$$
$$= \tilde{\Phi}\mathbf{I}^{(l)} + \varepsilon\mathbf{I}^{(0)} + \varepsilon\varsigma\mathbf{V}^{(l)},$$

Here, a condition $\tilde{\Phi} = \left[(1 - \varepsilon\varsigma)\mathbf{1} - \varepsilon\Phi^{\mathsf{T}}\Phi\right] \in \mathbb{R}^{WH\Lambda \times WH\Lambda}$ is satisfied, and ε denotes a gradient descent step size. For each optimization iteration stage, a hyperspectral image $I^{(l+1)}$ may be updated by calculating three terms shown in Equation 13, and this optimization process may be repeated N times. N is a natural number. In the second term of Equation 13, an initial value $I^{(0)}$ is represented as $I^{(0)} = \Phi^{\mathsf{T}}J$ and is weighted by the parameter ε. The third term of Equation 13 is a prior term and is weighted by $\varepsilon\varsigma$ in the iteration process.

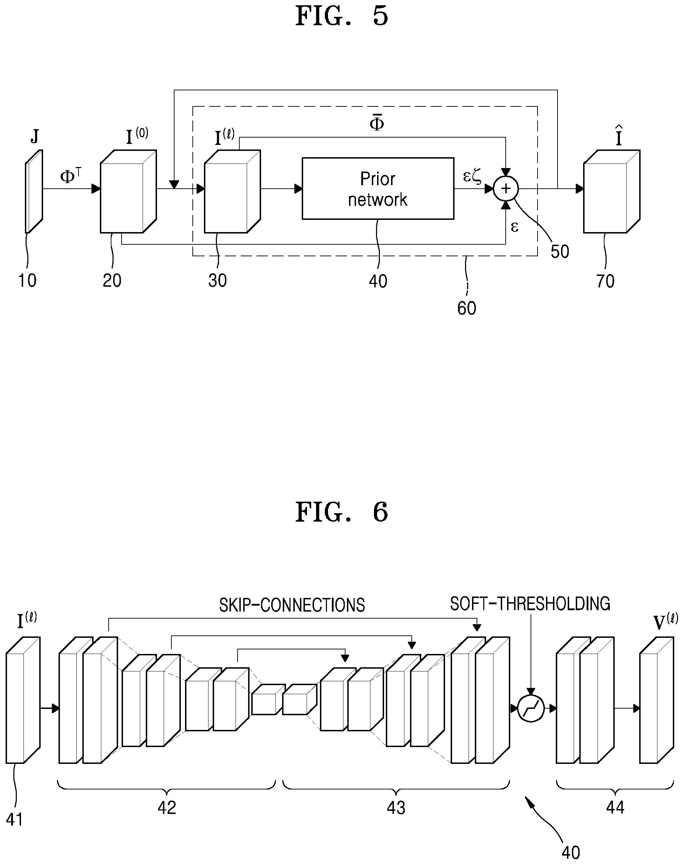

The solution of Equation 13 may be obtained through a neural network. For example, FIG. 5 is a block diagram conceptually illustrating a neural network structure for performing an optimization process to obtain a hyperspectral image. Referring to FIG. 5, the neural network structure may include an input unit 10 that receives image data J having an RGB channel from the solid-state imaging device 111, an initial value calculator 20 that calculates an initial value $I^{(0)}$ of a hyperspectral image based on the image data J provided from the input unit 10, an operation unit 60 that repeatedly performs the optimization process described in Equation 13 by using the gradient descent method, and an output unit 70 that outputs a final hyperspectral image after N iterations in the calculator 60.

The initial value calculator 20 provides the calculated initial value to the operation unit 60. In addition, the initial value calculator 20 is configured to calculate the second term of Equation 13 and to provide the operation unit 60 with a result of the calculation, that is, the product of a gradient descent step size and an initial value of a hyperspectral image. The operation unit 60 may include a first operation unit 30 configured to calculate the first term of Equation 13, a second operation unit 40 configured to calculate a prior term, which is the third term of Equation 13, and an adder 50 configured to add the output of the first operation unit 30, the output of the second operation unit 40, and the product of a gradient descent step size provided from the input unit 10 and an initial value of a hyperspectral image. The output of the adder 50 is repeatedly input to the first calculator 30 N times and repeatedly calculated. Finally, the output of the adder 50 may be provided to the output unit 70 after L iterations.

The image processor 120 may be configured to include such a neural network structure. Therefore, the above-described operation process may be performed in the image processor 120. For example, when an RGB image data obtained from the solid-state imaging device 111 is input to the image processor 120 including the neural network structure shown in FIG. 5, the image processor 120 may calculate each of the three terms in Equation 13 based on the RGB image data and add results of the calculation. In addition, the image processor 120 may be configured to update the hyperspectral image $I^{(l+1)}$ by recalculating the first and third terms in Equation 13 based on a result of the addition.

The image processor 120 may be configured to output a hyperspectral image obtained by repeating this process L times.

The prior term expressed by Equation 12 may be represented in the form of a proximal operator and may be solved through a neural network. For example, a network function $S(\cdot)$ for the hyperspectral image may be defined as $V^{(l+1)} = S(I^{(l+1)})$, and the network function $S(\cdot)$ may be solved in the form of a neural network having soft thresholding. For example, FIG. 6 is a block diagram conceptually illustrating a neural network structure of the second operation unit 40 for calculating the prior term shown in FIG. 5. Referring to FIG. 6, a U-net neural network may be adopted as the neural network structure of the second operation unit 40.

For example, the second operation unit 40 may include an input unit 41 that receives data from the first operation unit 30, an encoder 42 that generates a feature map based on the input data, a decoder 43 that restores the feature of data based on the feature map, and an output unit 44 that outputs restored data. The encoder 42 may include a plurality of pairs of a convolution layer and a pooling layer. Although three pairs of a convolution layer and a pooling layer are illustrated in FIG. 6, the number of pairs of a convolution layer and a pooling layer is not necessarily limited thereto, and more pairs of a convolution layer and a pooling layer may be used. The convolution layer of the encoder 42 may use a convolution filter having a size of $3\times3\times\Gamma$ to generate a tensor having a feature size of $\Gamma$. For example, $\Gamma$ may be set to 64 or more. For example, the pooling layer may use a max-pooling scheme.

The decoder 43 restores a feature by performing up-convolution. For example, the decoder 43 may include a plurality of pairs of up-sampling layers and convolution layers. Although three pairs of up-sampling layers and convolution layers are illustrated in FIG. 6, the number of pairs of up-sampling layers and convolution layers is not necessarily limited thereto, and more pairs of up-sampling layers and convolution layers may be used. The number of pairs of up-sampling layers and convolution layers of the decoder 43 is equal to the number of pairs of convolution layers and pooling layers of the encoder 42.

In addition, in order to improve the problem of losing information of a previous layer as the depth of a neural network increases, the neural network structure of the first operation unit 30 may use a skip connection method. For example, when the decoder 43 performs up-convolution, the decoder 43 may reflect data that has not undergone a pooling process in the pooling layer of the encoder 42, that is, data skipping the pooling process. This skip connection may be made between the convolution layer of the encoder 42 and the convolution layer of the decoder 43, which have the same data size.

The output of the decoder 43 is input to the output layer 44. The output layer 44 performs soft thresholding, with an activation function, on the output of the decoder 43 to achieve local gradient smoothness. Then, the two convolution layers are used to output a final result $V^{(l)}$ for the prior term. A convolution filter having a size of $3\times3\times\Lambda$ may be used as the convolution layer of the output layer 44. For example, $\Lambda$ may be set to 25, but is not necessarily limited thereto.

As described above, in the hyperspectral image pickup apparatus 100 according to the invention, chromatic dispersion is intentionally caused using the dispersion optical device 113, and the solid-state imaging device 111 obtains a dispersed image having an edge separated for each wavelength. Since the degree of chromatic dispersion by the dispersion optical device 113 is known in advance, a point spread function considering the dispersion optical device 113 is calculated for each wavelength, and based on the calculated point spread function, an image for each wavelength of the entire image may be inversely calculated through the above-described optimization process. Accordingly, by using the dispersion optical device 113, it is possible to miniaturize the hyperspectral image sensor 110 and the hyperspectral image pickup apparatus 100 including the hyperspectral image sensor 110. In addition, by using the hyperspectral image sensor 110 and the hyperspectral image pickup apparatus 100, a hyperspectral image may be obtained with only one shot.

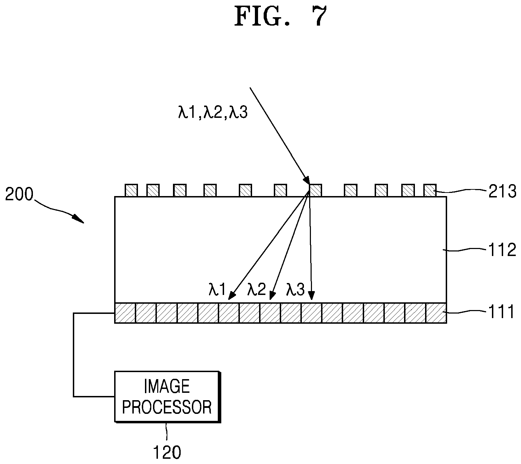

The hyperspectral image pickup apparatus 100 shown in FIG. 1 uses a separate objective lens 101 separated from the hyperspectral image sensor 110, but embodiments are not necessarily limited thereto. For example, FIG. 7 is a schematic cross-sectional view illustrating the configuration of a hyperspectral image pickup apparatus 200 according to another example embodiment. Referring to FIG. 7, the hyperspectral image pickup apparatus 200 may include a solid-state imaging device 111, a spacer 112, a dispersion optical device 213, and an image processor 120.

In the example embodiment shown in FIG. 7, the dispersion optical device 213 may be configured to also perform the role of an objective lens. For example, the dispersion optical device 213 may be configured to cause chromatic dispersion while focusing incident light on a light sensing surface of the solid-state imaging device 111. To this end, the dispersion optical device 213 may have various periodic or aperiodic grating structures. In particular, the dispersion optical device 213 may have a meta structure in which the sizes of unit patterns and the distance between the unit patterns are less than the wavelength of incident light.

In the hyperspectral image pickup apparatus 200 shown in FIG. 7, since the dispersion optical device 213 performs the function of an objective lens, a separate objective lens is not required. Therefore, the hyperspectral image pickup apparatus 200 shown in FIG. 7 may be further miniaturized.

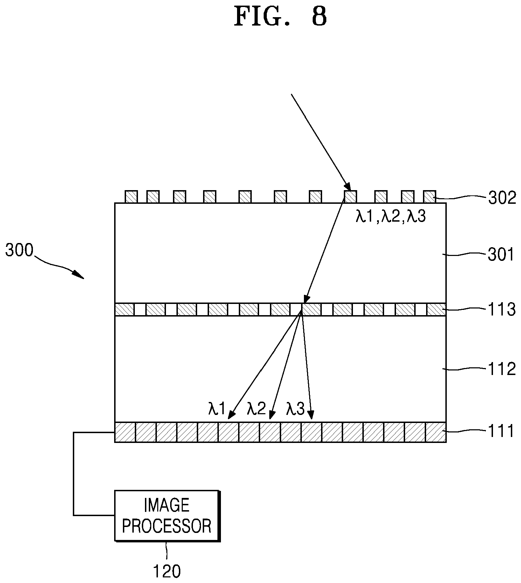

FIG. 8 is a schematic cross-sectional view illustrating the configuration of a hyperspectral image pickup apparatus 300 according to another example embodiment. Referring to FIG. 8, the hyperspectral image pickup apparatus 300 may include a solid-state imaging device 111, a first spacer 112 disposed on a light incident surface of the solid-state imaging device 111, a dispersion optical device 113 disposed on an upper surface of the first spacer 112, a second spacer 301 disposed on an upper surface of the dispersion optical device 113, a planar lens 302 disposed on an upper surface of the second spacer 301, and an image processor 120.

Compared to the hyperspectral image pickup apparatus 100 shown in FIG. 1, the hyperspectral image pickup apparatus 300 shown in FIG. 8 may include the planar lens 302 instead of the objective lens 101. The dispersion optical device 113 of the hyperspectral image pickup apparatus 300 may perform a role of causing chromatic dispersion, similar to the dispersion optical device 113 of the example embodiment shown in FIG. 1. The planar lens 302 is disposed on the upper surface of the second spacer 301 to perform the same role as the objective lens 101. For example, the planar lens 302 may be a Fresnel lens, a diffractive optical element, or a meta lens configured to focus incident light on the solid-state imaging device 111.

The hyperspectral image pickup apparatus 300 shown in FIG. 8 may be smaller in size than the hyperspectral image pickup apparatus 100 shown in FIG. 1. In addition, the dispersion optical device 113 and the planar lens 302 of the hyperspectral image pickup apparatus 300 shown in FIG. 8 may be easier to design and manufacture than the dispersion optical device 213 shown in FIG. 7.

While the above-described hyperspectral image sensor and the hyperspectral image pickup apparatus including the hyperspectral image sensor have been particularly shown and described with reference to example embodiments thereof, it will be understood by those of ordinary skill in the art that various changes in form and details may be made therein without departing from the scope of the disclosure as defined by the appended claims. The example embodiments should be considered in descriptive sense only and not for purposes of limitation.

While example embodiments have been described with reference to the figures, it will be understood by those of ordinary skill in the art that various changes in form and details may be made therein without departing from the scope as defined by the following claims.

## Claims

1. A hyperspectral image pickup apparatus (100, 200, 300) comprising: a

   hyperspectral image sensor (110) comprising a solid-state imaging device (111) comprising a plurality of pixels disposed two-dimensionally and configured to sense light and a dispersion optical device (113, 213) disposed to face the solid-state imaging device (111) at an interval and configured to cause chromatic dispersion of incident light such that the incident light is separated based on wavelengths of the incident light and is incident on different positions, respectively, on a light sensing surface of the solid-state imaging device (111); and an image processor (120) configured to process image data provided from the solid-state imaging device (111) to extract hyperspectral images for the plurality of wavelengths,
   wherein the image processor (120) is further configured to extract a hyperspectral image based on the RGB image provided from the solid-state imaging device (111) and a point spread function previously calculated for each of the plurality of wavelengths,
   wherein the image processor (120) is further configured to:

   extract edge information without dispersion through edge reconstruction of a dispersed RGB image input from the solid-state imaging device (111),
   obtain spectral information in a gradient domain based on dispersion of the extracted edge information, and reconstruct the hyperspectral image based on the spectral information of gradients.

2. The hyperspectral image pickup apparatus (100, 200, 300) of claim 1, further comprising;

   a transparent spacer (112) disposed on the light sensing surface of the solid-state imaging device (111), wherein the dispersion optical device (113, 213) is disposed on an upper surface of the transparent spacer (112) opposite to the solid-state imaging device (111); and/or
   wherein the dispersion optical device (113, 213) comprises a periodic grating structure or an aperiodic grating structure, or a one-dimensional structure, a two-dimensional structure, or a three-dimensional structure comprising materials having different refractive indices; and/or
   wherein a size of the dispersion optical device (113, 213) corresponds to all of the plurality of pixels of the solid-state imaging device (111).

3. The hyperspectral image pickup apparatus (100, 200, 300) of claim 1 or 2, further comprising an objective lens (101) configured to focus incident light on the light sensing surface of the solid-state imaging device (111); and/or
   wherein the dispersion optical device is configured to cause chromatic dispersion and focus incident light on the solid-state imaging device (113, 213).

4. The hyperspectral image pickup apparatus (100, 200, 300) of one of claims 1 to 3, further comprising:

a further spacer (301) disposed on an upper surface of the dispersion optical device (113, 213); and
a planar lens (302) disposed on an upper surface of the further spacer (301),
wherein the planar lens (302) is configured to focus incident light on the solid-state imaging device (111).

5. The hyperspectral image pickup apparatus (100, 200, 300) of claim 4, wherein the image processor (120) is further configured to obtain a spatially aligned hyperspectral image $i_{aligned}$ by solving a convex optimization problem by:

$$i_{aligned} = \underset{i}{\arg\min} \underbrace{\left\|\Omega\Phi i - j\right\|_2^2}_{\text{data term}} + \underbrace{\alpha_1 \left\|\nabla_{xy} i\right\|_1 + \beta_1 \left\|\nabla_\lambda \nabla_{xy} i\right\|_1}_{\text{prior terms}},$$

where $\Omega$ is a response characteristic of the solid-state imaging device, $\Phi$ is the point spread function, $j$ is the dispersed RGB image data input from the solid-state imaging device (111), $i$ is a vectorized hyperspectral image, $\nabla_{xy}$ is a spatial gradient operator, and $\nabla_\lambda$ is a spectral gradient operator.

6. The hyperspectral image pickup apparatus (100, 200, 300) of claim 5, wherein the image processor (120) is further configured to solve the convex optimization problem based on an alternating direction method of multipliers, ADMM, algorithm;
and/or

wherein the image processor (120) is further configured to reconstruct the spectral information from data of the spatially aligned hyperspectral image by solving an optimization problem to extract a stack $\hat{g}_{xy}$ of spatial gradients for each wavelength by:

$$\hat{g}_{xy} = \underset{g_{xy}}{\arg\min} \underbrace{\left\|\Omega\Phi g_{xy} - \nabla_{xy} j\right\|_2^2}_{\text{data term}} + \underbrace{\alpha_2 \left\|\nabla_\lambda g_{xy}\right\|_1 + \beta_2 \left\|\nabla_{xy} g_{xy}\right\|_2^2}_{\text{prior terms}},$$

where $g_{xy}$ is a spatial gradient close to a spatial gradient $\nabla_{xy} j$ of an image in the solid-state imaging device (111), preferably,
wherein the image processor (120) is further configured to reconstruct a hyperspectral image $i_{opt}$ from the stack $\hat{g}_{xy}$ of spatial gradients by solving an optimization problem by:

$$i_{opt} = \underset{i}{\arg\min} \underbrace{\left\|\Omega\Phi i - j\right\|_2^2 + \alpha_3 \left\|W_{xy} \odot \left(\nabla_{xy} i - \hat{g}_{xy}\right)\right\|_2^2}_{\text{data terms}} + \underbrace{\beta_3 \left\|\Delta_\lambda i\right\|_2^2}_{\text{prior term}},$$

where $\Delta_\lambda$ is a Laplacian operator for a spectral image $i$ along a spectral axis, and $W_{xy}$ is an element-wise weighting matrix that determines a confidence level of gradients estimated in a previous stage.

7. The hyperspectral image pickup apparatus (100, 200, 300) of claim 3, wherein the image processor (120) further comprises a neural network structure configured to repeatedly perform an optimization process based on a gradient descent method by:

$$I^{(l+1)} = I^{(l)} - \varepsilon\left[\Phi^{\top}\left(\Phi I^{(l)} - J\right) + \varsigma\left(I^{(l)} - V^{(l)}\right)\right]$$
$$= \tilde{\Phi} I^{(l)} + \varepsilon I^{(0)} + \varepsilon\varsigma V^{(l)},$$

where $I^{(l)}$ and $V^{(l)}$ are solutions for 1-th half-quadratic splitting - HQS - iteration, a condition

$$\bar{\Phi} = [(1 - \varepsilon\varsigma)1 - \varepsilon\Phi^{\mathsf{T}}\Phi] \in \mathbb{R}^{WH\Lambda \times WH\Lambda}$$

is satisfied, $\Phi$ is the point spread function, J is the dispersed RGB image data input from the solid-state imaging device (111), I is a vectorized hyperspectral image, $\varepsilon$ is a gradient descent step size, $\varsigma$ is a penalty parameter, V is an auxiliary variable $V \in \mathbb{R}^{WH\Lambda \times 1}$, and W, H, and $\Lambda$ are a width of a spectral image, a height of the spectral image, and a number of wavelength channels of the spectral image, respectively.

8. The hyperspectral image pickup apparatus (100, 200, 300) of claim 7, wherein the neural network structure of the image processor (120) is further configured to receive the dispersed image data J from the solid-state imaging device (111), obtain an initial value $I^{(0)}$ of the hyperspectral image based on the image data J, iteratively perform the optimization process based on the gradient descent method, and output a final hyperspectral image based on the iterative optimization process, preferably,

   wherein the image processor (120) is further configured to obtain a prior term, which is a third term, by using a neural network, more preferably,
   wherein the neural network comprises a U-net neural network.

9. The hyperspectral image pickup apparatus (100, 200, 300) of claim 8, wherein the neural network further comprises:

   an encoder (42) comprising a plurality of pairs of a convolution layer and a pooling layer; and
   a decoder (43) comprising a plurality of pairs of an up-sampling layer and a convolution layer,
   wherein a number of pairs of the up-sampling layer and the convolution layer of the decoder (43) is equal to a number of pairs of the convolution layer and the pooling layer of the encoder (42), and
   wherein a skip connection method is applied between the convolution layer of the encoder (42) and the convolution layer of the decoder (43), which have a same data size, preferably, wherein the neural network further comprises an output layer (44) configured to perform soft thresholding, based on an activation function, on the output of the decoder (43).

## Patentansprüche

1. Eine hyperspektrale Bildaufnahmevorrichtung (100, 200, 300), umfassend:

   einen hyperspektralen Bildsensor (110), der eine Festkörper-Bildgebungsvorrichtung (111) umfasst, die eine Vielzahl von Pixeln umfasst, die zweidimensional angeordnet und dazu konfiguriert sind, Licht zu erfassen, und eine optische Dispersionsvorrichtung (113, 213), die so angeordnet ist, dass sie der Festkörper-Bildgebungsvorrichtung (111) in einem Intervall zugewandt ist, und die so konfiguriert ist, dass sie eine chromatische Dispersion einfallenden Lichts bewirkt, so dass das einfallende Licht auf der Grundlage der Wellenlängen des einfallenden Lichts getrennt wird und jeweils auf verschiedene Positionen auf einer Lichterfassungsoberfläche der Festkörper-Bildgebungsvorrichtung (111) einfällt; und
   einen Bildprozessor (120), der dazu konfiguriert ist, von der Festkörper-Bildgebungsvorrichtung (111) gelieferte Bilddaten zu verarbeiten, um hyperspektrale Bilder für die Vielzahl von Wellenlängen zu extrahieren, wobei der Bildprozessor (120) ferner dazu konfiguriert ist, ein hyperspektrales Bild auf der Grundlage des von der Festkörper-Bildgebungsvorrichtung (111) gelieferten RGB-Bildes und einer zuvor für jede der Vielzahl von Wellenlängen berechneten Punktspreizfunktion zu extrahieren, wobei der Bildprozessor (120) ferner dazu konfiguriert ist:

      Kanteninformationen ohne Dispersion durch Kantenrekonstruktion eines dispergierten RGB-Bildes, das von der Festkörper-Bildgebungsvorrichtung (111) eingegeben wird, zu extrahieren,
      Spektralinformationen in einem Gradientenbereich auf der Grundlage von Dispersion der extrahierten Kanteninformationen zu erhalten, und
      das Hyperspektralbild auf der Grundlage der spektralen Information der Gradienten zu rekonstruieren.

2. Die hyperspektrale Bildaufnahmevorrichtung (100, 200, 300) nach Patentanspruch 1, ferner umfassend:

   einen transparenten Abstandshalter (112), der auf der Lichterfassungsoberfläche der Festkörper-Bildgebungsvorrichtung (111) angeordnet ist, wobei die optische Dispersionsvorrichtung (113, 213) auf einer oberen Fläche des transparenten Abstandshalters (112) gegenüber der Festkörper-Bildgebungsvorrichtung (111) angeordnet ist; und/oder

wobei die optische Dispersionsvorrichtung (113, 213) eine periodische Gitterstruktur oder eine aperiodische Gitterstruktur oder eine eindimensionale Struktur, eine zweidimensionale Struktur oder eine dreidimensionale Struktur aus Materialien mit unterschiedlichen Brechungsindizes umfasst; und/oder

wobei eine Größe der optischen Dispersionsvorrichtung (113, 213) der Gesamtheit der Vielzahl von Pixeln der Festkörper-Bildgebungsvorrichtung (111) entspricht.

3. Die hyperspektrale Bildaufnahmevorrichtung (100, 200, 300) nach Patentanspruch 1 oder 2, ferner umfassend eine Objektivlinse (101), die dazu konfiguriert ist, einfallendes Licht auf die Lichterfassungsoberfläche der Festkörper-Bildaufnahmevorrichtung (111) zu fokussieren; und/oder

wobei die optische Dispersionsvorrichtung dazu konfiguriert ist, eine chromatische Dispersion zu verursachen und einfallendes Licht auf die Festkörper-Bildgebungsvorrichtung (113, 213) zu fokussieren.

4. Die hyperspektrale Bildaufnahmevorrichtung (100, 200, 300) nach einem der Patentansprüche 1 bis 3, ferner umfassend:

einen weiteren Abstandshalter (301), der auf einer oberen Fläche der optischen Dispersionsvorrichtung (113, 213) angeordnet ist; und

eine planare Linse (302), die auf einer oberen Fläche des weiteren Abstandshalters (301) angeordnet ist, wobei die planare Linse (302) dazu konfiguriert ist, einfallendes Licht auf die Festkörper-Bildgebungsvorrichtung (111) zu fokussieren.

5. Die hyperspektrale Bildaufnahmevorrichtung (100, 200, 300) nach Patentanspruch 4, wobei der Bildprozessor (120) ferner dazu konfiguriert ist, ein räumlich ausgerichtetes hyperspektrales Bild $i_{ausgerichtet}$ durch Lösen eines konvexen Optimierungsproblems zu erhalten:

$$i_{ausgerichtet} = \arg\min_i \underbrace{\left|\left|\Omega\Phi i - j\right|\right|_2^2}_{Datenterm} + \underbrace{\alpha_1\left|\left|\nabla_{xy}i\right|\right|_1 + \beta_1\left|\left|\nabla_\lambda\nabla_{xy}i\right|\right|_1}_{vorherige\ Terme},$$

wobei $\Omega$ eine Ansprechcharakteristik der Festkörper-Bildgebungsvorrichtung ist, $\Phi$ die Punktspreizungsfunktion ist, j die dispergierten RGB-Bilddaten sind, die von der Festkörper-Bildgebungsvorrichtung (111) eingegeben werden, i ein vektorisiertes Hyperspektralbild ist, $\nabla_{xy}$ ein räumlicher Gradientenoperator ist und $\nabla_\lambda$ ein spektraler Gradientenoperator ist.

6. Die hyperspektrale Bildaufnahmevorrichtung (100, 200, 300) nach Patentanspruch 5, wobei der Bildprozessor (120) ferner dazu konfiguriert ist, das konvexe Optimierungsproblem auf der Grundlage eines ADMM-Algorithmus (alternating direction method of multipliers) zu lösen; und/oder

wobei der Bildprozessor (120) ferner dazu konfiguriert ist, die Spektralinformationen aus Daten des räumlich ausgerichteten Hyperspektralbildes durch Lösen eines Optimierungsproblems, um einen Stapel $\hat{g}_{xy}$ räumlicher Gradienten für jede Wellenlänge zu extrahieren, zu rekonstruieren:

$$\hat{g}_{xy} = \arg\min_{g_{xy}} \underbrace{\left|\left|\Omega\Phi g_{xy} - \nabla_{xy}j\right|\right|_2^2}_{Datenterm} + \underbrace{\alpha_2\left|\left|\nabla_\lambda g_{xy}\right|\right|_1 + \beta_2\left|\left|\nabla_{xy}g_{xy}\right|\right|_2^2}_{vorherige\ Terme},$$

wobei $g_{xy}$ ein räumlicher Gradient nahe einem räumlichen Gradienten $\nabla_{xy}j$ eines Bildes in der Festkörper-Bildgebungsvorrichtung (111) ist,

vorzugsweise, wobei der Bildprozessor (120) ferner dazu konfiguriert ist, ein hyperspektrales Bild $i_{opt}$ aus dem Stapel $\hat{g}_{xy}$ von räumlichen Gradienten durch Lösen eines Optimierungsproblems zu rekonstruieren:

$$i_{opt} = \arg\min_i \underbrace{\left|\left|\Omega\Phi i - j\right|\right|_2^2 + \alpha_3||W_{xy} \odot (\nabla_{xy}i - \hat{g}_{xy})||_2^2}_{Datenterme} + \underbrace{\beta_3||\Delta_\lambda i||_2^2}_{vorheriger\ Term},$$

wobei $\Delta_\lambda$ ein Laplacian-Operator für ein spektrales Bild i entlang einer spektralen Achse ist und $W_{xy}$ eine elementweise Gewichtungsmatrix ist, die das Konfidenzniveau der in einer früheren Phase geschätzten Gradienten bestimmt.

**7.** Die hyperspektrale Bildaufnahmevorrichtung (100, 200, 300) nach Patentanspruch 3, wobei der Bildprozessor (120) ferner eine neuronale Netzwerkstruktur umfasst, die so konfiguriert ist, dass sie wiederholt einen Optimierungsprozess auf der Grundlage eines Gradientenabstiegsverfahrens durchführt:

$$I^{(l+1)} = I^{(l)} - \varepsilon\big[\Phi^T\big(\Phi I^{(l)} - J\big) + \varsigma\big(I^{(l)} - V^{(l)}\big)\big]$$
$$= \overline{\Phi}I^{(l)} + \varepsilon I^{(0)} + \varepsilon\varsigma V^{(l)}\,,$$

wobei $I^{(l)}$ und $V^{(l)}$ Lösungen für die I-te halbquadratische Aufspaltung - HQS - Iteration sind, eine Bedingung $\overline{\Phi} = [(1 - \varepsilon\varsigma)1 - \varepsilon\Phi^T\Phi] \in \mathbb{R}^{WH\Lambda x WH\Lambda}$ erfüllt ist, $\Phi$ die Punktspreizfunktion ist, J die dispergierten RGB-Bilddaten sind, die von der Festkörper-Bildgebungsvorrichtung (111) eingegeben werden, I ein vektorisiertes Hyperspektralbild ist, $\varepsilon$ eine Gradientenabstiegsschrittgröße ist, $\varsigma$ ein Strafparameter ist, V eine Hilfsvariable $V \in \mathbb{R}^{WH\Lambda x 1}$ ist und W, H und $\Lambda$ eine Breite eines Spektralbildes, eine Höhe des Spektralbildes bzw. eine Anzahl von Wellenlängenkanälen des Spektralbildes sind.

**8.** Die hyperspektrale Bildaufnahmevorrichtung (100, 200, 300) nach Patentanspruch 7, wobei die neuronale Netzwerkstruktur des Bildprozessors (120) ferner dazu konfiguriert ist, die dispergierten Bilddaten J von der Festkörper-Bildaufnahmevorrichtung (111) zu empfangen, einen Anfangswert $I^{(0)}$ des hyperspektralen Bildes auf der Grundlage der Bilddaten J zu erhalten, den Optimierungsprozess auf der Grundlage des Gradientenabstiegsverfahrens iterativ durchzuführen und ein endgültiges hyperspektrales Bild auf der Grundlage des iterativen Optimierungsprozesses auszugeben, vorzugsweise,
wobei der Bildprozessor (120) ferner dazu konfiguriert ist, einen vorherigen Term, der ein dritter Term ist, unter Verwendung eines neuronalen Netzes zu erhalten, mehr bevorzugt, wobei das neuronale Netz ein neuronales U-Netz umfasst.

**9.** Die hyperspektrale Bildaufnahmevorrichtung (100, 200, 300) nach Patentanspruch 8, wobei das neuronale Netz weiterhin umfasst:

einen Kodierer (42), der eine Vielzahl von Paaren aus einer Faltungsschicht und einer Pooling-Schicht umfasst; und
einen Dekodierer (43), der eine Vielzahl von Paaren einer Aufwärtsabtastschicht und einer Faltungsschicht umfasst,
wobei eine Anzahl von Paaren der Aufwärtsabtastschicht und der Faltungsschicht des Dekodierers (43) gleich einer Anzahl von Paaren der Faltungsschicht und der Pooling-Schicht des Kodierers (42) ist, und
wobei ein Skip-Verbindungsverfahren zwischen der Faltungsschicht des Kodierers (42) und der Faltungsschicht des Dekodierers (43) angewendet wird, die dieselbe Datengröße haben, vorzugsweise wobei das neuronale Netz ferner eine Ausgangsschicht (44) umfasst, die dazu konfiguriert ist, auf der Grundlage einer Aktivierungsfunktion eine weiche Schwellenwertbildung an der Ausgabe des Dekodierers (43) durchzuführen.

## Revendications

**1.** Appareil de capture d'images hyperspectrales (100, 200, 300) comprenant :

un capteur d'images hyperspectrales (110) comprenant un dispositif d'imagerie à semi-conducteurs (111) comprenant une pluralité de pixels disposés en deux dimensions et configurés pour détecter la lumière et un dispositif optique de dispersion (113, 213) disposé face au dispositif d'imagerie à semi-conducteurs (111) à un intervalle et configuré pour provoquer une dispersion chromatique de la lumière incidente de sorte que la lumière incidente est séparée en fonction des longueurs d'ondes de la lumière incidente et est incidente sur différentes positions, respectivement, sur une surface de détection de la lumière du dispositif d'imagerie à semi-conducteurs (111) ; et
un processeur d'images (120) configuré pour traiter les données d'images fournies par le dispositif d'imagerie à semi-conducteurs (111) afin d'extraire des images hyperspectrales pour la pluralité de longueurs d'ondes, le processeur d'images (120) est en outre configuré pour extraire une image hyperspectrale basée sur l'image RVB fournie par le dispositif d'imagerie à semi-conducteurs (111) et une fonction d'étalement du point préalablement calculée pour chacune de la pluralité de longueurs d'ondes,

dans lequel le processeur d'images (120) est en outre configuré pour :

extraire des informations sur les bords sans dispersion par reconstruction des bords d'une image RVB dispersée provenant du dispositif d'imagerie à semi-conducteurs (111),
obtenir des informations spectrales dans un domaine de gradient sur la base de la dispersion des informations de bord extraites, et
reconstruire l'image hyperspectrale sur la base des informations spectrales des gradients.

2. Appareil de capture d'images hyperspectrales (100, 200, 300) selon la revendication 1, comprenant en outre ;

un espaceur transparent (112) disposé sur la surface de détection de la lumière du dispositif d'imagerie à semi-conducteurs (111), dans lequel le dispositif optique de dispersion (113, 213) est disposé sur une surface supérieure de l'espaceur transparent (112) à l'opposé du dispositif d'imagerie à semi-conducteurs (111) ; et/ou
dans lequel le dispositif optique de dispersion (113, 213) comprend une structure de réseau périodique ou une structure de réseau apériodique, ou une structure unidimensionnelle, une structure bidimensionnelle ou une structure tridimensionnelle comprenant des matériaux ayant des indices de réfraction différents ; et/ou
dans lequel une taille du dispositif optique de dispersion (113, 213) correspond à l'ensemble de la pluralité de pixels du dispositif d'imagerie à semi-conducteurs (111).

3. Appareil de capture d'images hyperspectrales (100, 200, 300) selon la revendication 1 ou 2, comprenant en outre une lentille d'objectif (101) configurée pour focaliser la lumière incidente sur la surface de détection de la lumière du dispositif d'imagerie à semi-conducteurs (111) ; et/ou
dans lequel le dispositif optique de dispersion est configuré pour provoquer une dispersion chromatique et focaliser la lumière incidente sur le dispositif d'imagerie à semi-conducteurs (113, 213).

4. Appareil de capture d'images hyperspectrales (100, 200, 300) selon l'une quelconque des revendications 1 à 3, comprenant en outre :

un espaceur supplémentaire (301) disposé sur une surface supérieure du dispositif optique de dispersion (113, 213) ; et
une lentille planaire (302) disposée sur une surface supérieure de l'espaceur supplémentaire (301), dans lequel la lentille planaire (302) est configurée pour focaliser la lumière incidente sur le dispositif d'imagerie à semi-conducteurs (111).

5. Appareil de capture d'images hyperspectrales (100, 200, 300) selon la revendication 4, dans lequel le processeur d'images (120) est en outre configuré pour obtenir une image hyperspectrale spatialement $i_{alignée}$ en résolvant un problème d'optimisation convexe par :

$$i_{\text{aligned}} = \operatorname{argmin} \underbrace{\|\Omega\Phi i - j\|_2^2}_{terme\ de\ données} + \underbrace{\alpha_1 \|\nabla_{xy} i\|_1 + \beta_1 \|\nabla_\lambda \nabla_{xy} i\|_1}_{termes\ antérieurs}$$

où $\Omega$ est une caractéristique de réponse du dispositif d'imagerie à semi-conducteurs, $\Phi$ est la fonction d'étalement du point, j est l'entrée de données d'images RVB dispersées provenant du dispositif d'imagerie à semi-conducteurs (111), i est une image hyperspectrale vectorisée, $\nabla_{xy}$ est un opérateur de gradient spatial, et $\nabla_\lambda$ est un opérateur de gradient spectral.

6. Appareil de capture d'images hyperspectrales (100, 200, 300) selon la revendication 5, dans lequel le processeur d'images (120) est en outre configuré pour résoudre le problème d'optimisation convexe sur la base d'une méthode de multiplicateurs à direction alternée, ADMM; et/ou

dans lequel le processeur d'images (120) est en outre configuré pour reconstruire les informations spectrales à partir des données de l'image hyperspectrale alignée spatialement en résolvant un problème d'optimisation pour extraire une pile $\hat{g}_{xy}$ de gradients spatiaux pour chaque longueur d'onde :

$$\hat{g}_{xy} = \arg\min \underbrace{\left\| \Omega \Phi g_{xy} - \nabla_{xy}j \right\|_2^2}_{terme\ de\ données} + \underbrace{\alpha_2 \left\| \nabla_\lambda g_{xy} \right\|_1 + \beta_2 \left\| \nabla_{xy} g_{xy} \right\|_2^2}_{termes\ antérieurs}$$

où $\hat{g}_{xy}$ est un gradient spatial proche d'un gradient spatial $\nabla_{xy}j$ d'une image dans le dispositif d'imagerie à semi-conducteurs (111),
de préférence,
dans lequel le processeur d'images (120) est en outre configuré pour reconstruire une image hyperspectrale $i_{opt}$ à partir de la pile $\hat{g}_{xy}$ de gradients spatiaux en résolvant un problème d'optimisation par :

$$i_{opt} = \arg\min \underbrace{\left\| \Omega \Phi i - j \right\|_2^2 + \alpha_3 \left\| W_{xy} \odot (\nabla_{xy}i - \hat{g}_{xy}) \right\|_2^2}_{termes\ de\ données} + \underbrace{\beta_3 \left\| \Delta_\lambda i \right\|_2^2}_{terme\ antérieur}$$

où $\Delta_\lambda$ est un opérateur laplacien pour une image spectrale i le long d'un axe spectral, et $W_{xy}$ est une matrice de pondération par éléments qui détermine le niveau de confiance des gradients estimés lors d'une étape précédente.

7. Appareil de capture d'images hyperspectrales (100, 200, 300) selon la revendication 3, dans lequel le processeur d'images (120) comprend en outre une structure de réseau neuronal configurée pour effectuer de manière répétée un processus d'optimisation basé sur un procédé de descente de gradient par :

$$I^{(l+1)} = I^{(l)} - \varepsilon \left[ \Phi^T (\Phi I^{(l)} - J) + \varsigma(I^l - V^l) \right]$$
$$= \Phi I^{(l)} + \varepsilon I^{(0)} + \varepsilon \varsigma V^{(l)}$$

où $I^{(l)}$ et $V^{(l)}$ sont des solutions pour la 1-ième itération du fractionnement semi-quadratique - HQS -, une condition $\Phi = \left[ (1 - \varepsilon\varsigma)1 - \varepsilon\Phi T\Phi \right] \in R^{WH\Lambda \times WH\Lambda}$ est satisfaite, $\Phi$ est la fonction d'étalement du point, J est l'entrée de données d'images RVB dispersées provenant du dispositif d'imagerie à semi-conducteurs (111), 1 est une image hyperspectrale vectorisée, $\varepsilon$ est une taille de pas de descente de gradient, $\varsigma$ est un paramètre de pénalité, V est une variable auxiliaire $V \in R^{WH\Lambda x1}$ et W, H et $\Lambda$ sont respectivement la largeur d'une image spectrale, la hauteur de l'image spectrale et le nombre de canaux de longueurs d'ondes de l'image spectrale.

8. Appareil de capture d'images hyperspectrales (100, 200, 300) selon la revendication 7, dans lequel la structure de réseau neuronal du processeur d'images (120) est en outre configurée pour recevoir les données d'images dispersées J du dispositif d'imagerie à semi-conducteurs (111), obtenir une valeur initiale $I^{(0)}$ de l'image hyperspectrale basée sur les données d'images J, effectuer de manière itérative le processus d'optimisation basé sur le procédé de descente de gradient, et produire une image hyperspectrale finale basée sur le processus d'optimisation itératif, de préférence,

dans lequel le processeur d'images (120) est en outre configuré pour obtenir un terme antérieur, qui est un troisième terme, à l'aide d'un réseau neuronal, de préférence,
dans lequel le réseau neuronal comprend un réseau neuronal en U.

9. Appareil de capture d'images hyperspectrales (100, 200, 300) selon la revendication 8, dans lequel le réseau neuronal comprend en outre :

un codeur (42) comprenant plusieurs paires d'une couche de convolution et d'une couche de mise en commun ; et
un décodeur (43) comprenant plusieurs paires d'une couche d'échantillonnage supérieur et d'une couche de convolution,
dans lequel un nombre de paires de la couche d'échantillonnage supérieur et de la couche de convolution du décodeur (43) est égal à un nombre de paires de la couche de convolution et de la couche de mise en commun du codeur (42), et
dans lequel un procédé de saut de connexion est appliqué entre la couche de convolution du codeur (42) et la couche de convolution du décodeur (43), qui ont la même taille de données, de préférence, dans lequel le réseau neuronal comprend en outre une couche de sortie (44) configurée pour effectuer un seuillage doux, sur la base d'une fonction d'activation, sur la sortie du décodeur (43).

# FIG. 1

## FIG. 2A

113

## FIG. 2B

113

FIG. 2C

113

FIG. 2D

113

# FIG. 3A

L0

111

# FIG. 3B

L1

L2

L3

111

N2

N3

N1

FIG. 4A

# FIG. 4B

# FIG. 4C

# FIG. 5

# FIG. 6

# FIG. 7

λ1,λ2,λ3

200

213

112

λ1  λ2  λ3

111

IMAGE
PROCESSOR

120

# FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9426383 B1
- US 2010013979 A1
- US 2009180115 A1
- EP 1339237 A2